# EUROPEAN PATENT APPLICATION

(11) **EP 4 759 624 A1**
(43) Date of publication of application: **17.06.2026**
(21) Application number: 24882662.0
(22) Date of filing: 23.09.2024
(51) Int. Cl.: B60L 58/10, G01R 31/396, G01R 31/371, G07C 5/02, H04W 4/40

(54) **BATTERY DATA ANALYSIS SYSTEM AND OPERATING METHOD THEREOF**

(30) Priority: 23.10.2023 KR 20230142301
(71) Applicant: LG Energy Solution, Ltd., Seoul 07335 (KR)
(72) Inventor: JO, Jeong Jae, Daejeon 34122 (KR); LEE, Jun Hyok, Daejeon 34122 (KR)
(74) Representative: Goddar, Heinz J.
(86) International application number: PCT/KR2024/014276
(87) International publication number: WO 2025/089633

(57) **Abstract**

A battery data analysis system according to one embodiment disclosed herein includes an information acquisition device configured to detect ignition-on and ignition-off of a target vehicle, transmit battery data acquired from the target vehicle to a server, count the number of times the battery data is transmitted in an ignition-on section of the target vehicle, and transmit a cumulative transmission count signal to the server, and a server configured to determine a transmission state of the battery data of the target vehicle based on the result of the comparison of the number of battery data received in the ignition-on section of the target vehicle and the cumulative transmission count.

## Description

### TECHNICAL FIELD

### CROSS-REFERENCE TO RELATED APPLICATION

This application claims priority to and the benefit of Korean Patent Application No. 10-2023-0142301 filed in the Korean Intellectual Property Office on October 23, 2023, the entire contents of which are incorporated herein by reference.

### TECHNICAL FIELD

Embodiments disclosed herein relate to a battery data analysis system and a method of operating the same.

### BACKGROUND ART

Recently, as demand for portable electronic products such as laptops, video cameras, and portable phones increases rapidly, and as the development of electric vehicles, energy storage batteries, robots, satellites, and the like begins in earnest, the research on high-performance secondary batteries capable of repeated charging and discharging is actively being conducted.

Currently commercialized secondary batteries include a nickel cadmium battery, a nickel hydride battery, a nickel zinc battery, a lithium-ion battery, and the like, and among them, since the lithium-ion battery has advantages in that little memory effect occurs compared to the nickel-based secondary battery and thus charge/discharge may be freely performed, a self-discharge rate is very low, and an energy density is high, the lithium-ion secondary battery is attracting attention.

Meanwhile, to check states of secondary batteries included in electric vehicles (EVs), a server may collect battery data of the EV and provide the analyzed results to a user through the analysis of the battery data. However, in this case, the EV battery data stored in the server is analyzed collectively without verifying whether an EV is turned on or off or whether there is any missing data, and the analyzed results are provided to a user. Therefore, there is a problem that the accuracy and reliability of the analyzed results are reduced.

### DISCLOSURE

### TECHNICAL PROBLEM

Embodiments disclosed herein are directed to providing a battery data analysis system and a method of operating the same, in which battery data of a vehicle is analyzed.

Embodiments disclosed herein are also directed to providing a battery data analysis system and a method of operating the same, in which a transmission state of data may be determined.

Embodiments disclosed herein are also directed to providing a battery data analysis system and a method of operating the same, in which battery data included in a data group without any missing data among a plurality of data groups may be analyzed.

The objects of the embodiments disclosed herein are not limited to the above-described objects, and other objects that are not described will be able to be clearly understood by those skilled in the art to which the present disclosure pertains from the following description.

### TECHNICAL SOLUTION

A battery data analysis system according to one embodiment disclosed herein includes an information acquisition device configured to detect ignition-on and ignition-off of a target vehicle, transmit battery data acquired from the target vehicle to a server, count the number of times the battery data is transmitted in an ignition-on section of the target vehicle, and transmit a cumulative transmission count signal to the server, and a server configured to determine a transmission state of the battery data of the target vehicle based on the result of the comparison of the number of battery data received in the ignition-on section of the target vehicle and the cumulative transmission count.

According to one embodiment, the server may include a communication unit configured to receive the battery data and the cumulative transmission count signal from the information acquisition device, a storage configured to store information about a plurality of vehicles and information about a battery corresponding to each of the plurality of vehicles, and a controller configured to determine the transmission state of the battery data of the target vehicle.

According to one embodiment, the information acquisition device may transmit a wake-up signal corresponding to the ignition-on of the target vehicle, and the controller may detect information about the target vehicle from the information about the plurality of vehicles based on the wake-up signal and assign a group number to the battery data based on the wake-up signal and the information about the target vehicle.

According to one embodiment, the controller may classify the battery data based on the group number, the wake-up signal, and the cumulative transmission count signal to generate a plurality of data groups.

According to one embodiment, the controller may independently determine the transmission state of the battery data for each of the plurality of data groups.

According to one embodiment, the controller may analyze the battery data to generate analyzed results when the cumulative transmission count signal corresponds to the number of battery data received in the ignition-on section of the target vehicle and the information about the plurality of vehicles and the information about the battery of each of the plurality of vehicles include information about the target vehicle and information about a battery of the target vehicle.

According to one embodiment, the controller may be configured to store the analyzed results in the storage and provide the analyzed results to a user corresponding to the target vehicle.

According to one embodiment, the controller may determine that the transmission state of the battery data is abnormal and stores determined results in the storage when the cumulative transmission count signal differs from the number of battery data received in the ignition-on section of the target vehicle and the information about the plurality of vehicles and the information about the battery of each of the plurality of vehicles do not include information about the target vehicle and information about a battery of the target vehicle.

According to one embodiment, the controller may provide the determined results to a user of the target vehicle when the information about the plurality of vehicles includes the information about the target vehicle.

A method of analyzing battery data according to one embodiment disclosed herein includes an operation of detecting ignition-on and ignition-off of a target vehicle and transmitting battery data acquired from the target vehicle to a server, an operation of counting the number of times the battery data is transmitted in an ignition-on section of the target vehicle and transmitting a cumulative transmission count signal to the server, and an operation of determining a transmission state of the battery data of the target vehicle based on the result of the comparison of the number of battery data received in the ignition-on section of the target vehicle and the cumulative transmission count.

According to one embodiment, the operation of transmitting the battery data to the server may include an operation of transmitting a wake-up signal corresponding to the ignition-on of the target vehicle to the server.

According to one embodiment, the method may further include detecting information about the target vehicle from the information about the plurality of vehicles based on the wake-up signal, assigning a group number to the battery data based on the wake-up signal and the information about the target vehicle, and classifying the battery data based on the group number, the wake-up signal, and the cumulative transmission count signal to generate a plurality of data groups.

According to one embodiment, the operation of determining the transmission state may include independently determining the transmission state of the battery data for each of the plurality of data groups.

According to one embodiment, the method may further include an operation of analyzing the battery data to generate analyzed results when the cumulative transmission count signal corresponds to the number of battery data received in the ignition-on section of the target vehicle and the information about the plurality of vehicles and the information about the battery of each of the plurality of vehicles include information about the target vehicle and information about a battery of the target vehicle.

According to one embodiment, the method may further include an operation of storing the analyzed results and providing the analyzed results to a user corresponding to the target vehicle.

According to one embodiment, the method may further include an operation of determining that the transmission state of the battery data is abnormal and storing determined results in the storage when the cumulative transmission count signal differs from the number of battery data received in the ignition-on section of the target vehicle and the information about the plurality of vehicles and the information about the battery of each of the plurality of vehicles do not include information about the target vehicle and information about a battery of the target vehicle.

According to one embodiment, the method may further include an operation of providing the determined results to a user of the target vehicle when the information about the plurality of vehicles includes the information about the target vehicle.

A server according to one embodiment disclosed herein includes a communication unit configured to receive a cumulative transmission count signal including battery data of a target vehicle and transmission count information of the battery data in an ignition-on section of the target vehicle from an information acquisition device, a storage configured to store information about a plurality of vehicles and information about a battery corresponding to each of the plurality of vehicles, and a controller configured to determine a transmission state of the battery data of the target vehicle based on the result of the comparison of the number of battery data received in the ignition-on section of the target vehicle and the cumulative transmission count.

According to one embodiment, the controller may analyze the battery data to generate analyzed results when the cumulative transmission count signal corresponds to the number of battery data received in the ignition-on section of the target vehicle and the information about the plurality of vehicles and the information about the battery of each of the plurality of vehicles include information about the target vehicle and information about a battery of the target vehicle.

According to one embodiment, the controller may determine that the transmission state of the battery data is abnormal and stores determined results in the storage when the cumulative transmission count signal differs from the number of battery data received in the ignition-on section of the target vehicle and the information about the plurality of vehicles and the information about the battery of each of the plurality of vehicles do not include information about the target vehicle and information about a battery of the target vehicle.

Detailed matters of other embodiments are included in a detailed description and accompanying drawings.

### ADVANTAGEOUS EFFECTS

According to the battery data analysis system and the method of operating the same according to the embodiments disclosed herein, the battery data included in the vehicle can be analyzed.

According to the battery data analysis system and the method of operating the same according to the embodiments disclosed herein, the transmission state of the data can be determined.

According to the battery data analysis system and the method of operating the same according to the embodiments disclosed herein, it is possible to increase the accuracy of the battery data analysis by analyzing the battery data included in the data group without any missing data among the plurality of data groups.

The effects of the battery data analysis system and the method of operating the same according to the disclosure of the present document are not limited to the above-described effects, and other effects that are not described will be able to be clearly understood by those skilled in the art according to the disclosure of the present document.

### DESCRIPTION OF DRAWINGS

FIG. 1 is a block diagram showing a battery data analysis system according to one embodiment disclosed herein.
FIG. 2 is a view showing an operation of generating a plurality of data groups by the battery data analysis system according to one embodiment disclosed herein.
FIG. 3 is a view showing an operation of analyzing battery data by the battery data analysis system when there is no missing battery data.
FIG. 4 is a view showing an operation of determining a transmission state of the battery data by the battery data analysis system when there is missing battery data.
FIG. 5 is a flowchart showing a battery analyzing method according to one embodiment disclosed herein.

In the description of the drawings, the same or similar reference numerals may be used for the same or similar components.

### MODE FOR INVENTION

Hereinafter, embodiments of the present invention will be described with reference to the accompanying drawings. However, it should be understood that this is not intended to limit the present disclosure to specific embodiments and includes various modifications, equivalents, and/or alternatives of the embodiments of the present disclosure.

It should be understood that the embodiments of this document and the terms used herein are not intended to limit the technical features described herein to specific embodiments and include various modifications, equivalents, or substitutes of the corresponding embodiments. In the description of the drawings, similar reference numerals may be used for similar or related components. The singular form of a noun corresponding to an item may include one item or a plurality of items unless the relevant context clearly dictates otherwise.

In the present document, each of phrases such as "A or B," "at least one of A and B," "at least one of A or B," "A, B, or C," "at least one of A, B, and C," and "at least one of A, B, or C" may include any one of the items listed together in the corresponding phrase among these phrases or all possible combinations thereof. Terms such as "first," "second," "first," "second," "A," "B," "(a)," or "(b)" may simply be used to distinguish the corresponding component from another and do not limit the corresponding components in another aspect (e.g., importance or order).

In the present document, when a certain (e.g., a first) component is described as being "coupled," "connected," or "joined" to another (e.g., a second) component with or without the terms "functionally" or "communicatively" or "coupled" or "connected," this means that the certain component may be connected to another component directly (e.g., in a wired or wireless manner) or indirectly (e.g., through a third component).

A method according to various embodiments disclosed herein may be provided to be included in a computer program product. The computer program product may be traded between sellers and buyers as commodities. The computer program product may be distributed in the form of a device-readable storage medium (e.g., a compact disc read only memory (CD-ROM)) or distributed (e.g., downloaded or uploaded) through application stores or directly online between two user devices. In the case of the online distribution, at least some of the computer program products may be at least temporarily stored or temporarily generated in a device-readable storage medium such as a memory of a server of a manufacturer, a server of an application store, or a relay server.

According to the embodiments disclosed herein, each component (e.g., a module or a program) of the above-described components may include a single object or a plurality of objects, and some of the plurality of objects may be separately disposed in another component. According to the embodiments disclosed herein, one or more components or operations among the above-described corresponding components may be omitted, or one or more other components or operations may be added. Alternatively or additionally, the plurality of components (e.g., modules or programs) may be integrated into one component. In this case, the integrated component may perform one or more functions of each of the plurality of components identically or similarly to those performed by the corresponding component of the plurality of components before the integration. According to the embodiments disclosed herein, operations performed by modules, programs, or other components may be executed sequentially, in parallel, repeatedly, or heuristically, or one or more of the operations may be executed in a different order or omitted, or one or more other operations may be added.

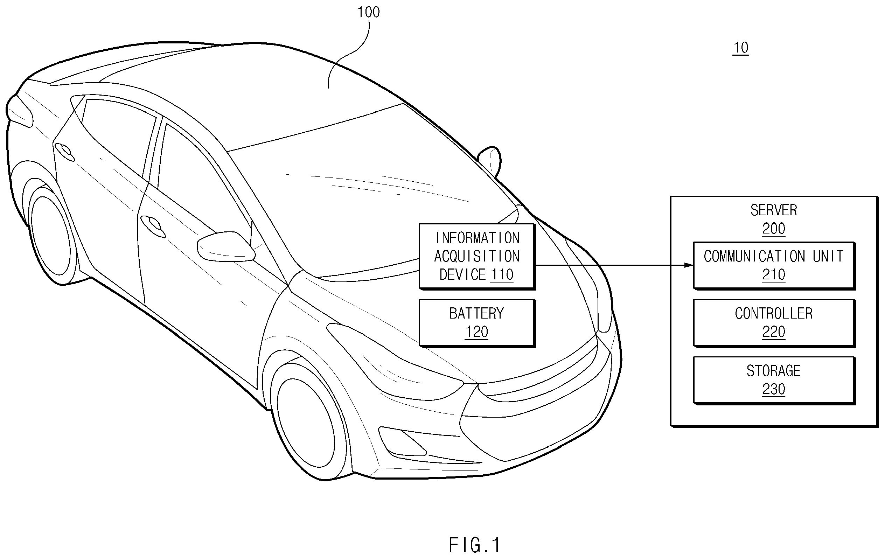

FIG. 1 is a block diagram showing a battery data analysis system according to one embodiment disclosed herein.

Referring to FIG. 1, a battery data analysis system 10 may include a target vehicle 100 and a server 200. The battery data analysis system 10 may analyze battery data of the target vehicle 100 in the server 200.

The target vehicle 100 may be an electric vehicle. The target vehicle 100 may be an electric vehicle including a battery 120. That is, the target vehicle 100 may be an electric vehicle (EV), a hybrid EV (HEV), a plug-in HEV (PHEV), or a fuel cell EV (FCEV) that includes the battery 120.

The target vehicle 100 may include an information acquisition device 110. Here, the information acquisition device 110 may include an onboard diagnostics (OBD). That is, the information acquisition device 110 may acquire data of the target vehicle 100 and data on the battery 120 included in the target vehicle 100.

The information acquisition device 110 may detect the ignition-on and ignition-off of the target vehicle 100. Here, the ignition-on corresponds to the engine-on of the target vehicle 100, and the ignition-off corresponds to the engine-off of the target vehicle 100.

The information acquisition device 110 may generate a wake-up signal. According to an embodiment, the information acquisition device 110 may wake up by detecting the ignition-on of the target vehicle 100 and generate the wake-up signal. That is, the wake-up signal generated by the information acquisition device 110 may correspond to the ignition-on of the target vehicle 100.

The information acquisition device 110 may generate the wake-up signal. According to an embodiment, the information acquisition device 110 may transmit the wake-up signal to the server 200.

The information acquisition device 110 may generate battery data. According to an embodiment, the information acquisition device 110 may generate battery data based on a state of charge (SOC), a state of health (SOH), an open circuit voltage (OCV), charge capacity, discharge capacity, and the like of the battery 120 acquired from the battery 120.

According to an embodiment, the information acquisition device 110 may generate battery data at a predetermined cycle. The information acquisition device 110 may generate battery data at a regular cycle in an ignition-on section of the target device. For example, the information acquisition device 110 may generate battery data at a 5-minute cycle in the ignition-on section. Here, the ignition-on section may be a section from a time point when the information acquisition device 110 detects the ignition-on of the target device to a time point when the ignition-off of the target device is detected.

The information acquisition device 110 may transmit the battery data. According to an embodiment, the information acquisition device 110 may transmit the battery data to the server 200. For example, the information acquisition device 110 may transmit the battery data to the server 200 via Long Term Evolution (LTE) communication.

The information acquisition device 110 may count the number of times the battery data is transmitted. According to an embodiment, the information acquisition device 110 may count the number of times the battery data is transmitted in the ignition-on section. That is, the information acquisition device 110 may count the number of times the battery data is transmitted to the server 200 from the time point when the ignition-on of the target device is detected to the time point when the ignition-off of the target device is detected.

The information acquisition device 110 may transmit a cumulative transmission count signal. According to an embodiment, the information acquisition device 110 may generate the cumulative transmission count signal including information about the number of times the battery data is transmitted in the ignition-on section and transmit the cumulative transmission count signal to the server 200.

The information acquisition device 110 may transmit the cumulative transmission count signal in response to detecting the ignition-off of the target vehicle 100. That is, the information acquisition device 110 may detect the ignition-off of the target vehicle 100, count the number of times the battery data is transmitted in the ignition-on section, and generate and transmit the cumulative transmission count signal. That is, the detection of the ignition-off and transmission of the cumulative transmission count signal of the information acquisition device 11 may correspond to each other.

The server 200 may include a communication unit 210, a controller 220, and a storage 230. The server 200 may determine the transmission state of the battery data received from the information acquisition device 110 and analyze the battery data.

The communication unit 210 may communicate with the information acquisition device 110. According to an embodiment, the communication unit 210 may receive the wake-up signal, battery data, and cumulative transmission count signal from the information acquisition device 110.

The controller 220 may acquire information about the target vehicle 100 and information about the battery 120. The controller 220 may detect information about the target vehicle 100 from among a plurality of pieces of vehicle information stored in the storage 230. According to an embodiment, the controller 220 may confirm the target vehicle 100 corresponding to the information acquisition device 110 that transmits the wake-up signal based on the wake-up signal and detect information about the corresponding target vehicle 100 from among the plurality of pieces of vehicle information stored in the storage 230. In addition, the controller 220 may acquire information about the battery 120 corresponding to the information about the target vehicle 100 from the information about the battery 120 corresponding to each of the plurality of vehicles stored in the storage 230.

The controller 220 may assign a group number. The controller 220 may assign the group number based on the reception of the wake-up signal. That is, when receiving the wake-up signal, the controller 220 may assign the group number to be assigned to battery data received after the time point of receiving the wake-up signal. Here, the group number may be a criterion for distinguishing a data group generated by the controller 220. That is, a first data group A, a second data group B, and a third data group C, which will be described below, may be distinguished based on the group number. The controller 220 may assign the same group number to the battery data received between the time point of receiving the wake-up signal and the time point of receiving the cumulative transmission count signal.

The controller 220 may generate a data group. According to an embodiment, the controller 220 may classify the battery data received from the information acquisition device 110 to generate the data group. For example, the controller 220 may generate one data group by setting the time point of receiving the wake-up signal of the information acquisition device 110 to a start point and the time point of receiving the cumulative transmission count signal to an end point and aggregating the pieces of battery data received from the information acquisition device 110 between the start point and the end point. That is, the controller 220 may generate one data group by aggregating the pieces of battery data to which the same group number is assigned.

The controller 220 may generate a plurality of data groups. According to an embodiment, the controller 220 may generate a plurality of data groups based on the wake-up signal, the group number, the cumulative transmission count signal, and the battery data. For example, the controller 220 may assign a first group number to pieces of battery data received between a time point of receiving a first wake-up signal and a time point of receiving a first cumulative transmission count and generate a first data group A by aggregating the pieces of battery data to which the first group number is assigned. The controller 220 may assign a second group number to pieces of battery data received between a time point of receiving a second wake-up signal and a time point of receiving a second cumulative transmission count and generate a second data group B by aggregating the pieces of battery data to which the second group number is assigned. The controller 220 may assign a third group number to pieces of battery data received between a time point of receiving a third wake-up signal and a time point of receiving a third cumulative transmission count and generate a third data group C by aggregating the pieces of battery data to which the third group number is assigned.

The controller 220 may generate pieces of battery data generated between the ignition-on and ignition-off of the target device as one battery 120 group. That is, pieces of battery data generated between first ignition-on and first ignition-off of the target device can be defined as the first data group A by the controller 220, and pieces of battery data generated between second ignition-on and second ignition-off of the target device can be defined as the second data group B by the controller 220. Therefore, the controller 220 may classify a plurality of pieces of battery data received from the same target device into a plurality of data groups.

The controller 220 may determine the transmission state of the battery data. According to an embodiment, the controller 220 may independently determine the transmission state of the battery data for each of the plurality of data groups. That is, the controller 220 may independently determine the transmission state for each of the first data group A and the second data group B. Therefore, the determination of the transmission state for the first data group A may be separate from the second data group B.

The controller 220 may acquire the number of battery data received in the ignition-on section. Here, the ignition-on section may be a section from the time point when the communication unit 210 receives the wake-up signal to the time point when receiving the cumulative transmission count signal, but is not limited thereto. For example, an end point of the ignition-on section may be a separate ignition-off signal rather than the time point when the cumulative transmission count signal is received. Therefore, the ignition-on section may correspond to a section between the time point when the information acquisition device 110 detects the ignition-on and the time point when detecting the ignition-off.

The controller 220 may compare the number of battery data received in the ignition-on section with cumulative transmission count. That is, the controller 220 may compare the number of battery data included in the same data group and received in the ignition-on section with the cumulative transmission count included in the cumulative transmission count signal, and determine the transmission state of the battery data based on the result of the comparison.

The controller 220 may determine whether to analyze the battery data based on the information about the target vehicle 100 and the presence or absence of the information about the battery 120 of the target vehicle 100. The controller 220 may determine whether to analyze the battery data based on whether the information about the plurality of vehicles stored in the storage 230 includes the information about the target vehicle 100 and whether the information about the battery 120 stored in the storage 230 includes the information about the battery 120 of the target vehicle 100.

According to an embodiment, the controller 220 may analyze the battery data when the number of battery data received in the ignition-on section corresponds to the cumulative transmission count included in the cumulative transmission count signal, the information about the plurality of vehicles includes the information about the target vehicle 100, and the information about the battery 120 corresponding to each of the plurality of vehicles includes the information about the battery 120 of the target vehicle 100. That is, the controller 220 may analyze the battery data when the transmission state of the data is normal and there are no missing information about the target vehicle 100 and missing information about the battery 120.

In this case, the controller 220 may store the analyzed results of the battery data in the storage 230. In addition, the controller 220 may provide the analyzed results to a user corresponding to the target vehicle 100. For example, the controller 220 may provide the analyzed results of the battery data to a user terminal through the communication unit 210 and may also provide the analyzed results of the battery data through a display provided in the target vehicle 100.

According to an embodiment, the controller 220 may not analyze the battery data when the number of battery data received in the ignition-on section does not correspond to the cumulative transmission count included in the cumulative transmission count signal, the information about the plurality of vehicles does not include the information about the target vehicle 100, and the information about the battery 120 corresponding to each of the plurality of vehicles does not include the information about the battery 120 of the target vehicle 100.

The controller 220 may determine that the transmission state of the battery data is abnormal when the number of battery data received in the ignition-on section does not correspond to the cumulative transmission count included in the cumulative transmission count signal. In this case, the controller 220 may determine that there is missing battery data. The controller 220 may store the missing state of the battery data in the storage 230.

When the information about the plurality of vehicles does not include the information about the target vehicle 100, the controller 220 may determine that there is missing information about the target vehicle 100. In addition, when the information about the battery 120 corresponding to each of the plurality of vehicles does not include the information about the battery 120 of the target vehicle 100, the controller 220 may determine that there is missing information about the battery 120. In this case, individual error code may be generated for each of the missing information about the target vehicle 100 and the missing information about the battery 120 and stored in the storage 230.

According to an embodiment, the controller 220 may provide the user with the missing state of the battery data or the missing state of the information about the battery 120 when the information about the plurality of vehicles includes the information about the target vehicle 100, but the number of battery data received in the ignition-on section does not correspond to the cumulative transmission count included in the cumulative transmission count signal or the information about the battery 120 corresponding to each of the plurality of vehicles does not include the information about the battery 120 of the target vehicle 100. That is, the controller 220 may specify the target vehicle 100, but when not analyzing the battery data, the controller 220 may provide the user of the target vehicle 100 with information about the reason that does not analyze the battery data.

The storage 230 may store the data. According to an embodiment, the information about the plurality of vehicles and the information about the battery 120 corresponding to each of the plurality of vehicles may be stored. In addition, the storage 230 may store the transmission state, analyzed results, or error codes of the battery data of the target vehicle 100 determined by the controller 220.

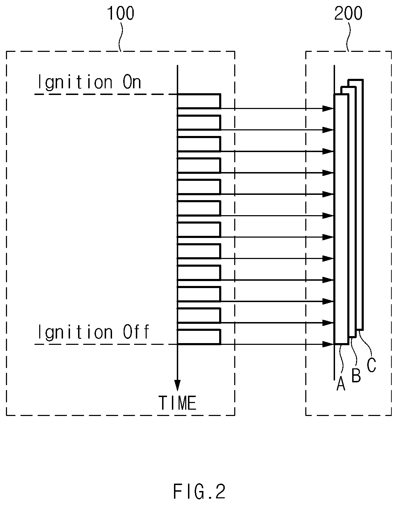

FIG. 2 is a view showing an operation of generating a plurality of data groups by the battery data analysis system according to one embodiment disclosed herein.

Referring to FIG. 2, the controller 220 may generate a plurality of data groups. First, the controller 220 may assign a group number. The controller 220 may assign the group number based on the reception of the wake-up signal. That is, when receiving the wake-up signal, the controller 220 may assign the group number to be assigned to battery data received after the time point of receiving the wake-up signal. The controller 220 may assign the same group number to the battery data received between the time point of receiving the wake-up signal and the time point of receiving the cumulative transmission count signal.

The controller 220 may generate a data group. According to an embodiment, the controller 220 may classify the battery data received from the information acquisition device 110 to generate the data group. For example, the controller 220 may generate one data group by setting the time point of receiving the wake-up signal of the information acquisition device 110 to a start point and the time point of receiving the cumulative transmission count signal to an end point and aggregating the pieces of battery data received from the information acquisition device 110 between the start point and the end point. That is, the controller 220 may generate one data group by aggregating the pieces of battery data to which the same group number is assigned.

The controller 220 may generate a plurality of data groups. According to an embodiment, the controller 220 may generate a plurality of data groups based on the wake-up signal, the group number, the cumulative transmission count signal, and the battery data. For example, the controller 220 may assign a first group number to pieces of battery data received between a time point of receiving a first wake-up signal and a time point of receiving a first cumulative transmission count and generate a first data group A by aggregating the pieces of battery data to which the first group number is assigned. The controller 220 may assign a second group number to pieces of battery data received between a time point of receiving a second wake-up signal and a time point of receiving a second cumulative transmission count and generate a second data group B by aggregating the pieces of battery data to which the second group number is assigned. The controller 220 may assign a third group number to pieces of battery data received between a time point of receiving a third wake-up signal and a time point of receiving a third cumulative transmission count and generate a third data group C by aggregating the pieces of battery data to which the third group number is assigned. Here, the first data group A, the second data group B, and the third data group C may be a set of pieces of battery data received from the same target vehicle 100.

The controller 220 may generate pieces of battery data generated between the ignition-on and ignition-off of the target device as one battery 120 group. That is, pieces of battery data generated between first ignition-on and first ignition-off of the target device can be defined as the first data group A by the controller 220, and pieces of battery data generated between second ignition-on and second ignition-off of the target device can be defined as the second data group B by the controller 220. Therefore, the controller 220 may classify a plurality of pieces of battery data received from the same target device into a plurality of data groups.

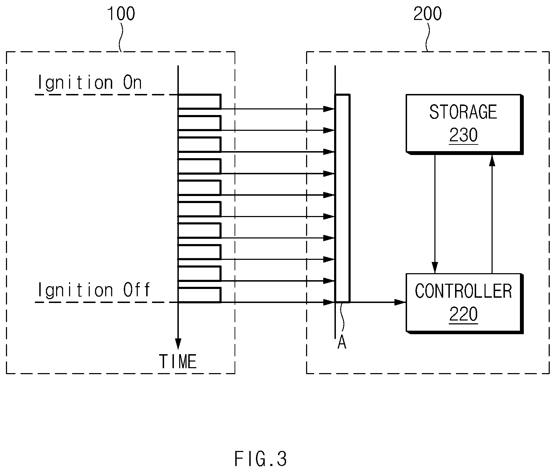

FIG. 3 is a view showing an operation of analyzing battery data by the battery data analysis system when there is no missing battery data.

Referring to FIG. 3, the controller 220 may determine whether to analyze data for each of the plurality of data groups. For convenience of description, the description will be made assuming that the controller 220 determines whether to analyze data for the first data group A.

The controller 220 may acquire the number of battery data received in the ignition-on section. Here, the ignition-on section may be a section from the time point when the communication unit 210 receives the wake-up signal to the time point when receiving the cumulative transmission count signal, but is not limited thereto. For example, an end point of the ignition-on section may be a separate ignition-off signal rather than the time point when the cumulative transmission count signal is received. Therefore, the ignition-on section may correspond to a section between the time point when the information acquisition device 110 detects the ignition-on and the time point when detecting the ignition-off.

The controller 220 may compare the number of battery data received in the ignition-on section with the cumulative transmission count. That is, the controller 220 may be included in the same data group, compare the number of battery data received in the ignition-on section with the cumulative transmission count included in the cumulative transmission count signal, and determine the transmission state of the battery data based on the result of the comparison.

The controller 220 may determine whether to analyze the battery data based on the information about the target vehicle 100 and the presence or absence of the information about the battery 120 of the target vehicle 100. The controller 220 may determine whether to analyze the battery data based on whether the information about the plurality of vehicles stored in the storage 230 includes the information about the target vehicle 100 and whether the information about the battery 120 stored in the storage 230 includes the information about the battery 120 of the target vehicle 100.

According to an embodiment, the controller 220 may analyze the battery data when the number of battery data received in the ignition-on section corresponds to the cumulative transmission count included in the cumulative transmission count signal, the information about the plurality of vehicles includes the information about the target vehicle 100, and the information about the battery 120 corresponding to each of the plurality of vehicles includes the information about the battery 120 of the target vehicle 100. That is, the controller 220 may analyze the battery data when the transmission state of the data is normal and there are no missing information about the target vehicle 100 and missing information about the battery 120.

In this case, the controller 220 may store the analyzed results of the battery data in the storage 230. In addition, the controller 220 may provide the analyzed results to a user corresponding to the target vehicle 100. For example, the controller 220 may provide the analyzed results of the battery data to a user terminal through the communication unit 210 and may also provide the analyzed results of the battery data through a display provided in the target vehicle 100.

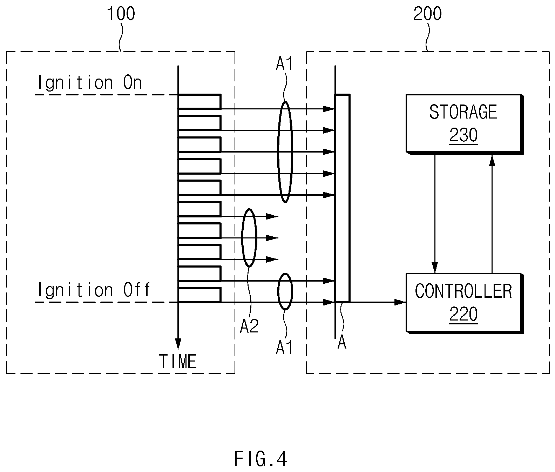

FIG. 4 is a view showing an operation of determining a transmission state of the battery data by the battery data analysis system when there is missing battery data.

Referring to FIG. 4, the controller 220 may determine the transmission state of the battery data. First, the controller 220 may compare the number of battery data received in the ignition-on section with the cumulative transmission count. When there is missing battery data, the battery data transmitted by the information acquisition device 110 to the server 200 may be classified into transmission data A1 and missing data A2. Here, the transmission data A1 can be defined as battery data transmitted by the information acquisition device 110 and received by the server 200, and the missing data A2 can be defined as data transmitted by an information processing device but not received by the server 200.

Since the missing data A2 is not received by the server 200, the missing data A2 may not be included in the plurality of data groups. Therefore, the first data group A may be composed of only the pieces of transmission data A1. Therefore, the number of battery data received by the server 200 in the ignition-on section may differ from the cumulative transmission count That is, since the missing data A2 is included in the cumulative transmission count but is not included in the number of battery data received in the ignition-on section, the number of battery data received in the ignition-on section may differ from the cumulative transmission count as much as the number of missing data A2.

According to an embodiment, the controller 220 may not analyze the battery data when the number of battery data received in the ignition-on section does not correspond to the cumulative transmission count included in the cumulative transmission count signal, the information about the plurality of vehicles does not include the information about the target vehicle 100, and the information about the battery 120 corresponding to each of the plurality of vehicles does not include the information about the battery 120 of the target vehicle 100.

The controller 220 may determine that the transmission state of the battery data is abnormal when the number of battery data received in the ignition-on section does not correspond to the cumulative transmission count included in the cumulative transmission count signal. In this case, the controller 220 may determine that there is missing battery data. That is, when the number of battery data received in the ignition-on section does not match the cumulative transmission count due to the presence of the missing data A2, the controller 220 may determine that the transmission state is abnormal and may not perform the data analysis of the first data group A. The controller 220 may store the missing state of the battery data in the storage 230.

When the information about the plurality of vehicles does not include the information about the target vehicle 100, the controller 220 may determine that there is missing information about the target vehicle 100. In addition, when the information about the battery 120 corresponding to each of the plurality of vehicles does not include the information about the battery 120 of the target vehicle 100, the controller 220 may determine that there is missing information about the battery 120. In this case, individual error code may be generated for each of the missing information about the target vehicle 100 and the missing information about the battery 120 and stored in the storage 230.

The battery data analysis system 10 may analyze battery data included in the vehicle. That is, the battery data analysis system 10 may collect and analyze battery data from the target vehicle 100 to analyze battery data.

The battery data analysis system 10 may analyze the transmission state of the battery data. The battery data analysis system 10 may compare the number of battery data transmitted by the information acquisition device 110 included in the target vehicle 100 with the number of battery data received by the server 200 to determine the transmission state of battery data.

The battery data analysis system 10 can improve the accuracy of battery data analysis by analyzing the battery data included in the data group without missing data among the plurality of data groups. The battery data analysis system 10 can improve the accuracy of battery data analysis by analyzing battery data for only a data group that does not have missing battery data among the plurality of data groups and includes the information about the target vehicle 100 and the information about the battery 120.

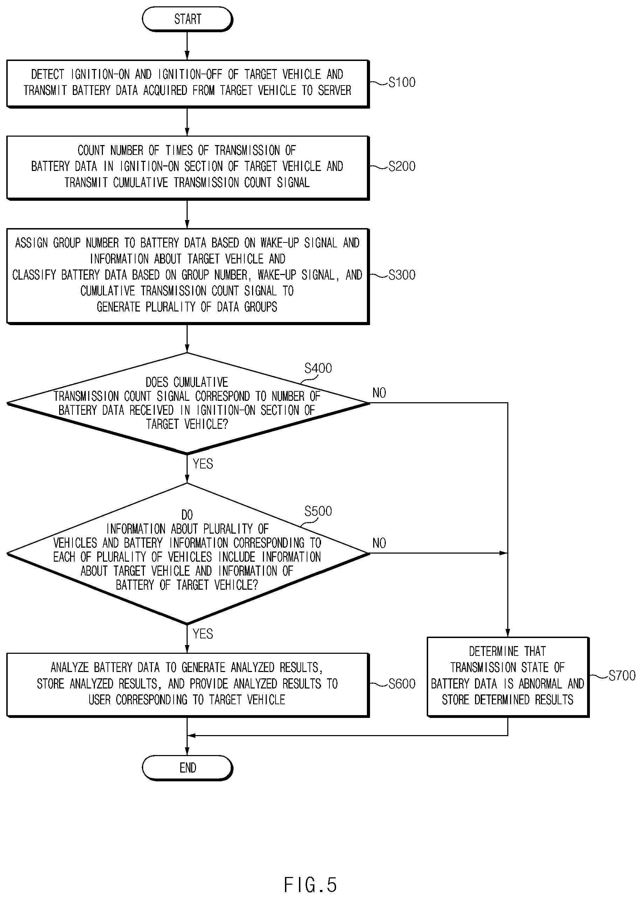

FIG. 5 is a flowchart showing a battery analyzing method according to one embodiment disclosed herein.

The embodiment illustrated in FIG. 5 is only one embodiment, the order of operations according to various embodiments of the present invention may be different from that illustrated in FIG. 5, and some operations illustrated in FIG. 5 may be omitted, the order between the operations may be changed, or the operations may be merged.

Referring to FIG. 5, a method of analyzing battery data may include an operation of detecting the ignition-on and ignition-off of the target vehicle 100 and transmitting battery data acquired from the target vehicle 100 to the server 200 (S100), an operation of counting the number of times the battery data is transmitted in the ignition-on section and transmitting a cumulative transmission count signal to the server 200 (S200), an operation of assigning a group number to the battery data based on the wake-up signal and the information about the target vehicle 100 and classifying the battery data based on the group number, the wake-up signal, and the cumulative transmission count signal to generate the plurality of data groups (S300), an operation of determining whether the cumulative transmission count signal corresponds to the number of battery data received in the ignition-on section of the target vehicle 100 (S400), an operation of determining whether the information about the plurality of vehicles and the information about the battery 120 corresponding to each of the plurality of vehicles include the information about the target vehicle 100 and the information about the battery 120 of the target vehicle 100 (S500), an operation of analyzing the battery data to generate analyzed results, storing the analyzed results, and providing the analyzed results to a user corresponding to the target vehicle 100 (S600), and an operation of determining that the transmission state of the battery data is abnormal and storing the determined results (S700).

Hereinafter, operations S100 to S700 will be described in detail with reference to FIGS. 1 to 4.

In operation S100, the battery data analysis system 10 may detect the ignition-on and ignition-off of the target vehicle 100 and transmit the battery data acquired from the target vehicle 100 to the server 200.

The battery data analysis system 10 may detect the ignition-on and ignition-off of the target vehicle 100. Here, the ignition-on corresponds to the engine-on of the target vehicle 100, and the ignition-off corresponds to the engine-off of the target vehicle 100.

The battery data analysis system 10 may generate the wake-up signal. According to an embodiment, the battery data analysis system 10 may wake up when detecting the ignition-on of the target vehicle 100 and generate the wake-up signal. That is, the wake-up signal generated by the battery data analysis system 10 may correspond to the ignition-on of the target vehicle 100.

The battery data analysis system 10 may transmit the wake-up signal. According to an embodiment, the battery data analysis system 10 may transmit the wake-up signal to the server 200.

The battery data analysis system 10 may generate battery data. According to an embodiment, the battery data analysis device 10 may generate battery data based on a state of charge (SOC), a state of health (SOH), an open circuit voltage (OCV), charge capacity, discharge capacity, and the like of the battery 120 acquired from the battery 120.

According to an embodiment, the battery data analysis system 10 may generate battery data at a predetermined cycle. The battery data analysis system 10 may generate battery data at a regular cycle in the ignition-on section of the target device. For example, the battery data analysis system 10 may generate battery data at a 5-minute cycle in the ignition-on section. Here, the ignition-on section may be a section from the time point when the battery data analysis system 10 detects the ignition-on of the target device to the time point when detecting the ignition-off of the target device.

The battery data analysis system 10 may transmit battery data. According to an embodiment, the battery data analysis system 10 may transmit the battery data to the server 200. For example, the battery data analysis system 10 may transmit the battery data to the server 200 via LTE communication.

In operation S200, the battery data analysis system 10 may count the number of times battery data is transmitted in the ignition-on section of the target vehicle 100 and transmit the cumulative transmission count signal to the server 200.

The battery data analysis system 10 may count the number of times the battery data is transmitted. According to an embodiment, the battery data analysis system 10 may count the number of times the battery data is transmitted in the ignition-on section. That is, the battery data analysis system 10 may count the number of battery data transmitted to the server 200 from the time point of detecting the ignition-on of the target device to the time point of detecting the ignition-off of the target device.

The battery data analysis system 10 may transmit the cumulative transmission count signal. According to an embodiment, the battery data analysis system 10 may generate the cumulative transmission count signal including information about the number of times the battery data is transmitted in the ignition-on section and transmit the cumulative transmission count signal to the server 200.

The battery data analysis system 10 may transmit the cumulative transmission count signal in response to detecting the ignition-off of the target vehicle 100. That is, the battery data analysis system 10 may detect the ignition-off of the target vehicle 100, count the number of times the battery data is transmitted in the ignition-on section, and generate and transmit the cumulative transmission count signal. That is, the detection of the ignition-off and transmission of the cumulative transmission count signal of the battery data analysis system 10 may correspond to each other.

In operation S300, the battery data analysis system 10 may assign the group number to the battery data based on the wake-up signal and the information about the target vehicle 100 and classify the battery data based on the group number, the wake-up signal, and the cumulative transmission count signal to generate the plurality of data groups.

The battery data analysis system 10 may assign the group number. The battery data analysis system 10 may assign the group number based on the reception of the wake-up signal. That is, when receiving the wake-up signal, the battery data analysis system 10 may assign the group number to the pieces of battery data received after the time point of receiving the wake-up signal. Here, the group number may be a criterion for distinguishing the data group generated by the battery data analysis system 10. That is, the first data group A, the second data group B, and the third data group C, which will be described below, may be distinguished based on the group number. The battery data analysis system 10 may assign the same group number to the battery data received between the time point of receiving the wake-up signal and the time point of receiving the cumulative transmission count signal.

The battery data analysis system 10 may generate the data group. According to an embodiment, the battery data analysis system 10 may classify the battery data received from the battery data analysis system 10 to generate the data group. For example, the battery data analysis system 10 may generate one data group by setting the time point of receiving the wake-up signal of the battery data analysis system 10 to the start point and the time point of receiving the cumulative transmission count signal to the end point and aggregating the pieces of battery data received from the battery data analysis system 10 between the start point and the end point. That is, the battery data analysis system 10 may generate one data group by aggregating the pieces of battery data to which the same group number is assigned.

The battery data analysis system 10 may generate the plurality of data groups. According to an embodiment, the battery data analysis system 10 may generate a plurality of data groups based on the wake-up signal, the group number, the cumulative transmission count signal, and the battery data.

In operation S400, the battery data analysis system 10 may determine whether the cumulative transmission count signal corresponds to the number of battery data received in the ignition-on section of the target vehicle 100.

The battery data analysis system 10 may determine the transmission state of the battery data. According to an embodiment, the battery data analysis system 10 may independently determine the transmission state of the battery data for each of the plurality of data groups.

The battery data analysis system 10 may acquire the number of battery data received in the ignition-on section. Here, the ignition-on section may be a section from the time point when the communication unit 210 receives the wake-up signal to the time point when receiving the cumulative transmission count signal, but is not limited thereto. For example, an end point of the ignition-on section may be a separate ignition-off signal rather than the time point when the cumulative transmission count signal is received. Therefore, the ignition-on section may correspond to the section between the time point when the battery data analysis system 10 detects ignition-on and the time point when detecting the ignition-off.

The battery data analysis system 10 may compare the number of battery data received in the ignition-on section with the cumulative transmission count. That is, the battery data analysis system 10 may compare the number of battery data included in the same data group and received in the ignition-on section with the cumulative transmission count included in the cumulative transmission count signal and determine the transmission state of the battery data based on the result of the comparison.

When the number of battery data received in the ignition-on section corresponds to the cumulative transmission count, operation S500 may be performed. When the number of battery data received in the ignition-on section does not correspond to the cumulative transmission count, operation S700 may be performed.

In operation S500, the battery data analysis system 10 may determine whether the information about the plurality of vehicles and the information about the battery 120 corresponding to each of the plurality of vehicles include the information about the target vehicle 100 and the information about the battery 120 of the target vehicle 100.

The battery data analysis system 10 may determine whether to analyze the battery data based on the presence or absence of the information about the target vehicle 100 and the information about the battery 120 of the target vehicle 100. The battery data analysis system 10 may determine whether to analyze the battery data based on whether the information about the plurality of vehicles stored in the storage 230 includes the information about the target vehicle 100 and whether the information about the battery 120 stored in the storage 230 includes the information about the battery 120 of the target vehicle 100.

When the information about the plurality of vehicles includes the information about the target vehicle 100 and the information about the battery 120 corresponding to each of the plurality of vehicles includes the information about the battery 120 of the target vehicle 100, operation S600 may be performed. When the information about the plurality of vehicles does not include the information about the target vehicle 100 and the information about the battery 120 corresponding to each of the plurality of vehicles does not include the information about the battery 120 of the target vehicle 100, operation S700 may be performed.

In operation S600, the battery data analysis system 10 may analyze the battery data to generate analyzed results, store the analyzed results, and provide the analyzed results to the user corresponding to the target vehicle 100.

The battery data analysis system 10 may analyze the battery data when the number of battery data received in the ignition-on section corresponds to the cumulative transmission count included in the cumulative transmission count signal, the information about the plurality of vehicles includes the information about the target vehicle 100, and the information about the battery 120 corresponding to each of the plurality of vehicles includes the information about the battery 120 of the target vehicle 100. That is, the battery data analysis system 10 may analyze the battery data when the data transmission state is normal and there is no missing information about the target vehicle 100 and missing information about the battery 120.

In this case, the battery data analysis system 10 may store the analyzed results of the battery data in the storage 230. In addition, the battery data analysis system 10 may provide the analyzed results to the user corresponding to the target vehicle 100. For example, the battery data analysis system 10 may provide the analyzed results of the battery data to the user terminal through the communication unit 210 and also provide the analyzed results of the battery data through the display provided in the target vehicle 100.

In operation S700, the battery data analysis system 10 may determine that the transmission state of the battery data is abnormal and store determined results.

The battery data analysis system 10 may not analyze the battery data when the number of battery data received in the ignition-on section does not correspond to the cumulative transmission count included in the cumulative transmission count signal, the information about the plurality of vehicles does not include the information about the target vehicle 100, and the information about the battery 120 corresponding to each of the plurality of vehicles does not include the information about the battery 120 of the target vehicle 100.

The battery data analysis system 10 may determine that the transmission state of the battery data is abnormal when the number of battery data received in the ignition-on section does not correspond to the cumulative transmission count included in the cumulative transmission count signal. In this case, the battery data analysis system 10 may determine that there is missing battery data. The battery data analysis system 10 may store the missing state of the battery data in the storage 230.

When the information about the plurality of vehicles does not include the information about the target vehicle 100, the battery data analysis system 10 may determine that there is missing information about the target vehicle 100. In addition, when the information about the battery 120 corresponding to each of the plurality of vehicles does not include the information about the battery 120 of the target vehicle 100, the battery data analysis system 10 may determine that there is missing information about the battery 120. In this case, individual error code may be generated for each of the missing information about the target vehicle 100 and the missing information about the battery 120 and stored in the storage 230.

The above description is merely the exemplary description of the technical spirit disclosed herein, and those skilled in the art to which embodiments disclosed herein pertain will be able to variously modify and change the embodiments without departing from the essential characteristics of the embodiments disclosed herein.

Therefore, the embodiments disclosed herein are not intended to limit the technical spirit disclosed herein, but for describing it, and the scope of the technical spirit disclosed herein is not limited by these embodiments. The scope of the technical spirit disclosed herein should be construed by the appended claims, and all technical spirits within the equivalent range should be construed as being included in the scope of this document.

### [DESCRIPTION OF REFERENCE NUMERALS]

10: battery data analysis system
100: target vehicle
110: information acquisition device
200: server
210: communication unit
220: controller
230: storage

## Claims

1. A battery data collection system comprising:
an information acquisition device configured to detect ignition-on and ignition-off of a target vehicle, transmit battery data acquired from the target vehicle to a server, count the number of times the battery data is transmitted in an ignition-on section of the target vehicle, and transmit a cumulative transmission count signal to the server; and
a server configured to determine a transmission state of the battery data of the target vehicle based on the result of the comparison of the number of battery data received in the ignition-on section of the target vehicle and the cumulative transmission count.

2. The battery data collection system of claim 1, wherein the server includes:
a communication unit configured to receive the battery data and the cumulative transmission count signal from the information acquisition device;
a storage configured to store information about a plurality of vehicles and information about a battery corresponding to each of the plurality of vehicles; and
a controller configured to determine the transmission state of the battery data of the target vehicle.

3. The battery data collection system of claim 2, wherein the information acquisition device transmits a wake-up signal corresponding to the ignition-on of the target vehicle, and
the controller detects information about the target vehicle from the information about the plurality of vehicles based on the wake-up signal and
assigns a group number to the battery data based on the wake-up signal and the information about the target vehicle.

4. The battery data collection system of claim 3, wherein the controller classifies the battery data based on the group number, the wake-up signal, and the cumulative transmission count signal to generate a plurality of data groups.

5. The battery data collection system of claim 4, wherein the controller independently determines the transmission state of the battery data for each of the plurality of data groups.

6. The battery data collection system of claim 2, wherein the controller analyzes the battery data to generate analyzed results when the cumulative transmission count signal corresponds to the number of battery data received in the ignition-on section of the target vehicle and the information about the plurality of vehicles and the information about the battery of each of the plurality of vehicles include information about the target vehicle and information about a battery of the target vehicle.

7. The battery data collection system of claim 6, wherein the controller is configured to:
store the analyzed results in the storage; and
provide the analyzed results to a user corresponding to the target vehicle.

8. The battery data collection system of claim 2, wherein the controller determines that the transmission state of the battery data is abnormal and stores determined results in the storage when the cumulative transmission count signal differs from the number of battery data received in the ignition-on section of the target vehicle and the information about the plurality of vehicles and the information about the battery of each of the plurality of vehicles do not include information about the target vehicle and information about a battery of the target vehicle.

9. The battery data collection system of claim 8, wherein the controller provides the determined results to a user of the target vehicle when the information about the plurality of vehicles includes the information about the target vehicle.

10. A method of collecting battery data, the method comprising:
an operation of detecting ignition-on and ignition-off of a target vehicle and transmitting battery data acquired from the target vehicle to a server;
an operation of counting the number of times the battery data is transmitted in an ignition-on section of the target vehicle and transmitting a cumulative transmission count signal to the server; and
an operation of determining a transmission state of the battery data of the target vehicle based on the result of the comparison of the number of battery data received in the ignition-on section of the target vehicle and the cumulative transmission count.

11. The method of claim 10, wherein the operation of transmitting the battery data to the server includes an operation of transmitting a wake-up signal corresponding to the ignition-on of the target vehicle to the server.

12. The method of claim 11, further comprising:
detecting information about the target vehicle from the information about the plurality of vehicles based on the wake-up signal;
assigning a group number to the battery data based on the wake-up signal and the information about the target vehicle; and
classifying the battery data based on the group number, the wake-up signal, and the cumulative transmission count signal to generate a plurality of data groups.

13. The method of claim 12, wherein the operation of determining the transmission state includes independently determining the transmission state of the battery data for each of the plurality of data groups.

14. The method of claim 10, further comprising an operation of analyzing the battery data to generate analyzed results when the cumulative transmission count signal corresponds to the number of battery data received in the ignition-on section of the target vehicle and the information about the plurality of vehicles and the information about the battery of each of the plurality of vehicles include information about the target vehicle and information about a battery of the target vehicle.

15. The method of claim 14, further comprising an operation of storing the analyzed results and providing the analyzed results to a user corresponding to the target vehicle.

16. The method of claim 10, further comprising an operation of determining that the transmission state of the battery data is abnormal and storing determined results in the storage when the cumulative transmission count signal differs from the number of battery data received in the ignition-on section of the target vehicle and the information about the plurality of vehicles and the information about the battery of each of the plurality of vehicles do not include information about the target vehicle and information about a battery of the target vehicle.

17. The method of claim 16, further comprising an operation of providing the determined results to a user of the target vehicle when the information about the plurality of vehicles includes the information about the target vehicle.

18. A server comprising:
a communication unit configured to receive a cumulative transmission count signal including battery data of a target vehicle and transmission count information of the battery data in an ignition-on section of the target vehicle from an information acquisition device;
a storage configured to store information about a plurality of vehicles and information about a battery corresponding to each of the plurality of vehicles; and
a controller configured to determine a transmission state of the battery data of the target vehicle based on the result of the comparison of the number of battery data received in the ignition-on section of the target vehicle and the cumulative transmission count.

19. The server of claim 18, wherein the controller analyzes the battery data to generate analyzed results when the cumulative transmission count signal corresponds to the number of battery data received in the ignition-on section of the target vehicle and the information about the plurality of vehicles and the information about the battery of each of the plurality of vehicles include information about the target vehicle and information about a battery of the target vehicle.

20. The server of claim 18, wherein the controller determines that the transmission state of the battery data is abnormal and stores determined results in the storage when the cumulative transmission count signal differs from the number of battery data received in the ignition-on section of the target vehicle and the information about the plurality of vehicles and the information about the battery of each of the plurality of vehicles do not include information about the target vehicle and information about a battery of the target vehicle.
